# EUROPÄISCHE PATENTANMELDUNG

(11) **EP 4 495 981 A1**
(43) Veröffentlichungstag der Anmeldung: **22.01.2025**
(21) Anmeldenummer: 23185809.3
(22) Anmeldetag: 17.07.2023
(51) Int. Cl.: H01L 21/48, H01L 23/373

(54) **VERFAHREN ZUR HERSTELLUNG EINER HALBLEITERANORDNUNG MIT EINEM KÜHLKÖRPER**

(71) Anmelder: Siemens Aktiengesellschaft, 80333 München (DE)
(72) Erfinder: Kögler, Roman, 90403 Nürnberg (DE); Namyslo, Lutz, 91353 Hausen (DE); Schmenger, Jens, 91301 Forchheim (DE)
(74) Vertreter: Siemens Patent Attorneys

(57) **Zusammenfassung**

Die Erfindung betrifft ein Verfahren zur Herstellung einer Halbleiteranordnung (24) mit einem Kühlkörper (2). Um die Herstellungskosten zu senken, werden folgende Schritte vorgeschlagen: Bereitstellen eines Kühlkörpers (2), der aus einem ersten metallischen Werkstoff hergestellt ist, Aufbringen (A) eines zweiten metallischen Werkstoffs, welcher sich vom ersten metallischen Werkstoff unterscheidet, mittels eines thermischen Spritzverfahrens zur Ausbildung einer haftvermittelnden Schicht (16) auf zumindest einer, insbesondere ebenen, Oberfläche (10) des Kühlkörpers (2), wobei der zweite metallische Werkstoff erste Partikel (20) und zweite Partikel (22) enthält, wobei die ersten Partikel (20) und die zweiten Partikel (22) aus unterschiedlichen Elementen oder Legierungen hergestellt sind, stoffschlüssiges Verbinden (B) mindestens eines Substrats (26) auf der haftvermittelnden Schicht (16).

## Beschreibung

Die Erfindung betrifft ein Verfahren zur Herstellung einer Halbleiteranordnung mit einem Kühlkörper.

Ferner betrifft die Erfindung eine Halbleiteranordnung mit einem Kühlkörper.

Darüber hinaus betrifft die Erfindung einen Stromrichter mit mindestens einer derartigen Halbleiteranordnung.

In derartigen Stromrichtern werden in der Regel Halbleiteranordnungen auf einen Kühlkörper befestigt. Unter einem Stromrichter ist beispielsweise ein Gleichrichter, ein Wechselrichter, ein Umrichter oder ein Gleichspannungswandler zu verstehen. Üblicherweise sind die Halbleiteranordnungen als Elektronikmodule ausgeführt, die ein Gehäuse aufweisen und über eine massive metallische Bodenplatte auf den Kühlkörper aufgeschraubt sind. Ferner können die Halbleiteranordnungen unmittelbar, das heißt ohne ein zusätzliches Verbindungselement wie eine Grundplatte, mit dem Kühlkörper verbunden werden.

Zum stoffschlüssigen Verbinden von Komponenten auf dem Kühlkörper zur Herstellung einer Halbleiteranordnung kann eine haftvermittelnde Schicht erforderlich sein. Derartige Schichten werden beispielsweise aus Nickel durch Galvanisieren aufgebracht, was ein kostenintensiver Prozessschritt ist. Vor diesem Hintergrund ist es eine Aufgabe der vorliegenden Erfindung, die Herstellungskosten für eine Halbleiteranordnung zu senken.

Diese Aufgabe wird erfindungsgemäß gelöst durch ein Verfahren zur Herstellung einer Halbleiteranordnung mit einem Kühlkörper umfassend folgende Schritte: Bereitstellen eines Kühlkörpers, der aus einem ersten metallischen Werkstoff hergestellt ist, Aufbringen eines zweiten metallischen Werkstoffs, welcher sich vom ersten metallischen Werkstoff unterscheidet, mittels eines thermischen Spritzverfahrens zur Ausbildung einer haftvermittelnden Schicht auf zumindest einer, insbesondere ebenen, Oberfläche des Kühlkörpers, wobei der zweite metallische Werkstoff erste Partikel und zweite Partikel enthält, wobei die ersten Partikel und die zweiten Partikel aus unterschiedlichen Elementen oder Legierungen hergestellt sind, stoffschlüssiges Verbinden mindestens eines Substrats auf der haftvermittelnden Schicht.

Ferner wird die Aufgabe erfindungsgemäß gelöst durch eine Halbleiteranordnung mit einem Kühlkörper aus einem ersten metallischen Werkstoff, wobei auf zumindest einer, insbesondere ebenen, Oberfläche des Kühlkörpers eine haftvermittelnde Schicht aus einem zweiten metallischen Werkstoff, welcher sich vom ersten metallischen Werkstoff unterscheidet, angeordnet ist, wobei die haftvermittelnde Schicht mittels eines thermischen Spritzverfahrens aus ersten Partikeln und zweiten Partikeln des zweiten metallischen Werkstoffs hergestellt ist, wobei die ersten Partikel und die zweiten Partikel aus unterschiedlichen Elementen oder Legierungen hergestellt sind, wobei ein Substrat stoffschlüssig auf der haftvermittelnden Schicht verbunden ist.

Darüber hinaus wird die Aufgabe erfindungsgemäß durch einen Stromrichter mit mindestens einer derartigen Halbleiteranordnung gelöst.

Die in Bezug auf das Verfahren nachstehend angeführten Vorteile und bevorzugten Ausgestaltungen lassen sich sinngemäß auf die Halbleiteranordnung und den Stromrichter übertragen.

Der Erfindung liegt die Überlegung zugrunde, die Herstellungskosten für eine Halbleiteranordnung zu senken, dass eine haftvermittelnde Schicht aus einem zweiten metallischen Werkstoff mittels eines thermischen Spritzverfahrens auf eine Oberfläche eines Kühlkörpers aus einem ersten metallischen Werkstoff, welcher sich vom zweiten metallischen Werkstoff unterscheidet, insbesondere flächig, aufgetragen wird. Daraufhin wird ein Substrat stoffschlüssig mit der haftvermittelnden Schicht auf dem Kühlkörper verbunden. Derartige Spritzverfahren sind unter anderem Schmelzbadspritzen, Lichtbogenspritzen, Plasmaspritzen, Flammspritzen, Laserspritzen und Kaltgasspritzen. Für die stoffschlüssige Verbindung des Substrats kommen unter anderem Löten und Sintern infrage. Ein derartiges thermisches Spritzverfahren ist, insbesondere beim Auftragen einer dünnen haftvermittelnden Schicht, kostengünstiger als beispielsweise ein Galvanisieren mit Nickel.

Die haftvermittelnde Schicht wird aus ersten Partikeln und zweiten Partikeln des zweiten metallischen Werkstoffs, ausgebildet, die aus unterschiedlichen Elementen oder Legierungen hergestellt sind. Die Partikel werden durch ihre, insbesondere kinetische, Energie beim Aufprall verformt und bilden durch ein Haftgefüge den zweiten metallischen Werkstoff aus. Beispielsweise werden teure erste Partikel mit günstigeren zweiten Partikeln verschnitten, um Materialkosten zu senken, sodass die Herstellungskosten für die Halbleiteranordnung zusätzlich reduziert werden. Beispielsweise werden hochreine und teure metallische Partikel mit weniger reinen metallischen Partikeln, insbesondere aus einem Recyclingprozess, verschnitten, um Materialkosten zu sparen.

Eine weitere Ausführungsform sieht vor, dass die ersten Partikel und die zweiten Partikel zumindest hinsichtlich ihrer Wärmeleitfähigkeit und/oder ihrer Härte unterscheiden. Insbesondere werden Partikel mit einer hohen Wärmeleitfähigkeit verwendet, um eine ausreichende Wärmespreizung bzw. Wärmeabfuhr zu ermöglichen, während härtere Partikel beigemischt werden, um die Dichte und die Stabilität der Materialkombination zu erhöhen.

Eine weitere Ausführungsform sieht vor, dass die zweiten Partikel einen geringeren thermischen Ausdehnungskoeffizienten als die ersten Partikel aufweisen. Durch die Beimischung von Partikeln mit einem geringeren thermischen Ausdehnungskoeffizienten wird der Ausdehnungskoeffizient der haftvermittelnden Schicht, insbesondere in Bezug auf eine Keramik des Substrats, angeglichen, sodass Erhöhung der Lebensdauer der Anordnung erreicht wird.

Eine weitere Ausführungsform sieht vor, dass die ersten Partikel Kupfer und/oder Aluminium und die zweiten Partikel Eisen und/oder Zinn enthalten. Durch die Vermengung von, insbesondere hoch reinem, Kupfer mit kostengünstigeren Eisenpartikeln können die Kosten für die Beschichtung stark gesenkt werden. Ferner führt die größere Härte der Eisenpartikel zu einer Verbesserung der Abzugsfestigkeit bei geringer Verschlechterung der thermischen Leitfähigkeit. Beispielsweise können die zweiten Partikel aus einer Zinn-Eisen-Legierung hergestellt sein, welche eine niedrige Oxidationsgeschwindigkeit aufweist, sodass die Oberfläche einer Kupfer-Zinn-Eisen Mischung zusätzlich länger lötbar bleibt.

Eine weitere Ausführungsform sieht vor, dass der Kühlkörper aus einer Aluminiumlegierung mittels Strangpressen hergestellt wird. Ein stranggepresster Kühlkörper ist, beispielsweise im Vergleich zu einem gegossenen Kühlkörper, aus einer Aluminiumlegierung mit einem niedrigeren Siliziumanteil, z.B. von 0,1 % bis 1,0 %, insbesondere von 0,1 % bis 0,6 %, herstellbar, sodass eine verbesserte thermische Leitfähigkeit erreicht wird.

Eine weitere Ausführungsform sieht vor, dass der Anteil von ersten Partikeln im zweiten metallischen Werkstoff mindestens 60 % beträgt. Beispielsweise beträgt der Anteil von ersten Partikeln zu zweiten Partikeln im zweiten metallischen Werkstoff 1,5 bis 4 zu 1, insbesondere 1,5 bis 3 zu 1. Bei einem derartigen Verhältnis kommt es nur zu einer geringen Verschlechterung der thermischen Leitfähigkeit, wobei eine ausreichende Abzugsfestigkeit erreicht wird.

Eine weitere Ausführungsform sieht vor, dass sich die Partikel hinsichtlich ihrer Korngröße unterscheiden. Durch unterschiedliche Korngrößen wird die Dichte und somit die Stabilität der Materialkombination erhöht.

Eine weitere Ausführungsform sieht vor, dass die Partikel jeweils aus einem groben Pulver und aus einem feinen Pulver zusammensetzen, wobei das feine Pulver durch einen Recyclingprozess gewonnen wird. Beispielsweise setzen sich Kupfer- und Eisenpartikel jeweils aus gröberen Partikeln und feineren Recycling-Partikeln zusammen. Durch Verwendung von recycelten Partikeln werden die Kosten zusätzlich gesenkt und die Nachhaltigkeit der Anordnung verbessert.

Eine weitere Ausführungsform sieht vor, dass mittels des thermischen Spritzverfahrens eine haftvermittelnde Schicht mit einer, insbesondere im Wesentlichen konstanten, Stärke im Bereich von 50 µm bis 300 µm ausgebildet wird. Eine derartige Stärke ermöglicht eine zuverlässige stoffschlüssige Verbindung des Substrats auf dem Kühlkörper ohne merkliche Vergrö-βerung des thermischen Widerstandes.

Eine weitere Ausführungsform sieht vor, dass das stoffschlüssige Verbinden des Substrats mit der haftvermittelnden Schicht durch Löten oder Sintern erfolgt. Eine derartige Verbindung ist zuverlässig und kostengünstig herstellbar.

Eine weitere Ausführungsform sieht vor, dass nach dem stoffschlüssigen Verbinden des Substrats mindestens ein Halbleiterelement auf einer dem Kühlkörper abgewandten Seite des Substrats kontaktiert wird. Das Kontaktieren kann unter anderem kraftschlüssig oder durch eine stoffschlüssige Verbindung erfolgen. Das Halbleiterelement kann unter anderem als Insulated-Gate-Bipolar-Transistor (IGBT), als ein Metall-Oxid-Halbleiter-Feldeffekttransistoren (MOSFETs), als ein Leistungshalbleiter mit breiter Bandlücke, insbesondere GaN oder SiC Leistungshalbleiter, ausgeführt sein. Durch eine derartige Anordnung wird auf kostengünstige Weise eine zuverlässige Entwärmung des Halbleiterelements während eines Betriebes gewährleistet.

Im Folgenden wird die Erfindung anhand der in den Figuren dargestellten Ausführungsbeispiele näher beschrieben und erläutert.

Es zeigen:
- FIG 1: eine schematische dreidimensionale Schnittdarstellung eines Kühlkörpers für eine Halbleiteranordnung,
- FIG 2: eine vergrößerte schematische Schnittdarstellung eines Kühlkörpers,
- FIG 3: eine schematische Schnittdarstellung einer Halbleiteranordnung mit einem Kühlkörper,
- FIG 4: ein Ablaufdiagramm eines Verfahrens zur Herstellung einer Halbleiteranordnung und
- FIG 5: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

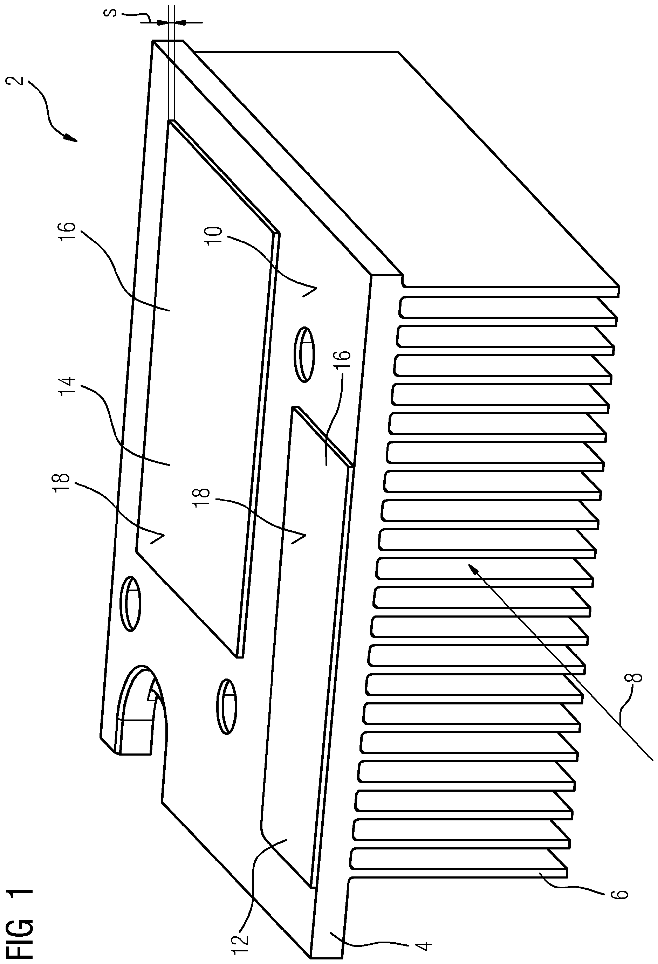

FIG 1 zeigt eine schematische dreidimensionale Schnittdarstellung eines Kühlkörpers 2 für eine Halbleiteranordnung. Der Kühlkörper 2 weist eine Grundplatte 4 mit Kühlrippen 6 auf, wobei die Kühlrippen 6 mit der Grundplatte 4 verbunden sind. Beispielhaft sind in FIG 1 die Grundplatte 4 und die Kühlrippen 6 des Kühlkörpers 2 einstückig ausgeführt. Der Kühlkörper 2 ist durch die Kühlrippen 6 konfiguriert, ein, insbesondere gasförmiges, Kühlfluid in eine Kühlmittelströmungsrichtung 8 zu leiten, wobei die Kühlmittelströmungsrichtung 8 im Wesentlichen parallel zu einer ebenen Oberfläche 10 verläuft. Das Kühlfluid ist beispielsweise Luft, die über einen Lüfter, der aus Gründen der Übersichtlichkeit in FIG 1 nicht dargestellt ist, in die Kühlmittelströmungsrichtung 8 über die Kühlrippen 6 des Kühlkörpers 2 strömt. Der Kühlkörper 2 ist aus einem ersten metallischen Werkstoff hergestellt. Der erste metallische Werkstoff kann unter anderem eine Aluminiumlegierung sein, welche beispielsweise einen Siliziumanteil von 0,1 % bis 1,0 %, insbesondere von 0,1 % bis 0,6 % enthält. Ein derartiger Kühlkörper 2 kann unter anderem mittels Strangpressen hergestellt sein.

Darüber hinaus weist der Kühlkörper 2 auf der Oberfläche 10 beispielhaft zwei Bereiche 12, 14 auf, die jeweils mit einer haftvermittelnden Schicht 16 versehen sind. Die haftvermittelnde Schicht 16 ist aus einem zweiten metallischen Werkstoff, welcher sich vom ersten metallischen Werkstoff unterscheidet, mittels eines thermischen Spritzverfahrens hergestellt. Als thermisches Spritzverfahren kommt unter anderem Kaltgasspritzen infrage. Die haftvermittelnde Schicht 16 weist eine im Wesentlichen konstante Stärke s im Bereich von 50 µm bis 300 µm auf, sodass jeweils eine parallel zur Oberfläche 10 verlaufende im Wesentlichen ebene Verbindungsfläche 18 ausgebildet ist. Die haftvermittelnde Schicht 16 dient dazu beispielsweise eine Metallisierung, insbesondere Kupfer-Metallisierung, eines Substrats mit dem Kühlkörper 2 stoffschlüssig, insbesondere durch Löten oder Sintern, zu verbinden.

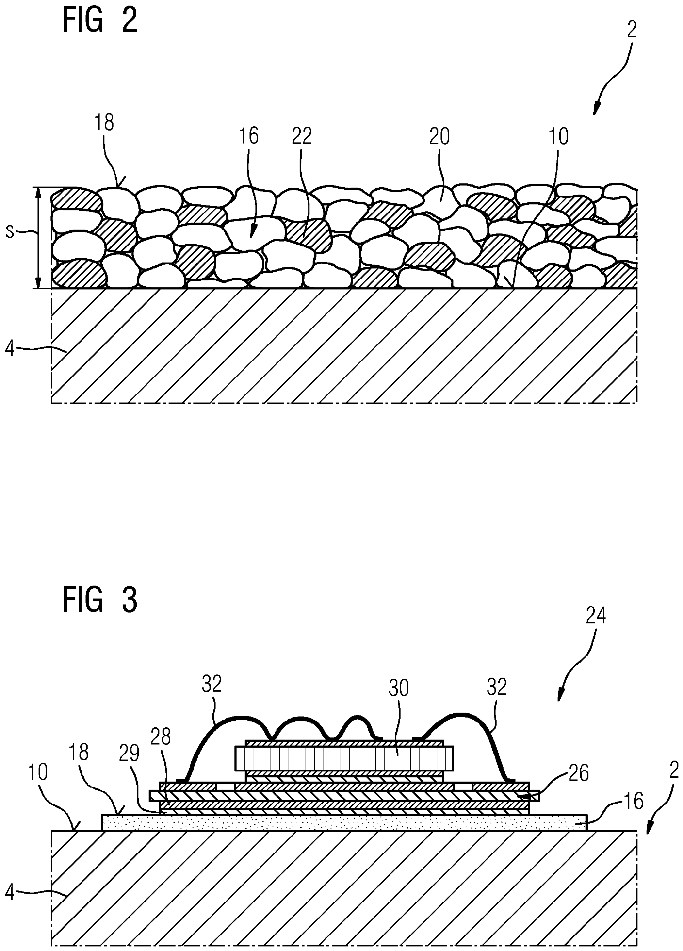

FIG 2 zeigt eine vergrößerte schematische Schnittdarstellung eines Kühlkörpers 2. Die haftvermittelnde Schicht 16, welche durch Kaltgasspritzen auf die Oberfläche 10 aufgebracht ist, ist aus einem zweiten metallischen Werkstoff hergestellt, der erste Partikel 20 und zweite Partikel 22 enthält. Die ersten Partikel 20 enthalten, insbesondere hochreines und somit teueres, Kupfer, während die zweiten Partikel 22 Eisen, insbesondere Reineisen, enthalten. Somit weisen die ersten Partikel 20 eine höhere Wärmeleitfähigkeit und elektrische Leitfähigkeit als die zweiten Partikel 22 auf, während die zweiten Partikel 22 im Vergleich zu den ersten Partikeln 20 eine größere Härte aufweisen. Alternativ können die zweiten Partikel 22 aus einer Zinn-Eisen-Legierung hergestellt sein, welche eine niedrige Oxidationsgeschwindigkeit aufweist, sodass die Oberfläche einer Kupfer-Zinn-Eisen Mischung zusätzlich länger lötbar bleibt.

Beispielsweise enthält die haftvermittelnde Schicht 16 60 % bis 80 % erste Partikel 20, während sich der Rest aus zweiten Partikeln 22 zusammensetzt. Somit beträgt das Mischverhältnis 1,5 zu 1 bis 4 zu 1. Durch Beimischung des härteren Eisens wird die Auftragseffektivität beim Kaltgasspritzen erhöhte, da durch die härteren zweiten Partikel 22 eine zusätzliche Verformungsenergie auf die weicheren ersten Partikel 20 ausgeübt wird, sodass sich die ersten Partikel 20 weiter verformen und die haftvermittelnde Schicht 16 stärker verfestigt wird. Die Wärmeleitfähigkeit der haftvermittelnde Schicht 16 fällt aufgrund der geringen Stärke s im pm-Bereich kaum ins Gewicht, während sich die Kostenposition erheblich verbessert.

Die Partikel 20, 22 können sich hinsichtlich ihrer Korngröße unterscheiden, was die Dickte zusätzlich erhöht und die Festigkeit der haftvermittelnden Schicht 16 verbessert. Beispielsweise können sich die Partikel 20, 22 jeweils aus einem groben Pulver und aus einem feinen Pulver zusammensetzen, wobei das feine Pulver durch einen Recyclingprozess gewonnen werden kann. Die weitere Ausführung des Kühlkörpers 2 in FIG 2 entspricht der Ausführung in FIG 1.

FIG 3 zeigt eine schematische Schnittdarstellung einer Halbleiteranordnung 24 mit einem Kühlkörper 2, welcher beispielsweise wie in einer der Figuren 1 oder 2 ausgeführt ist. Ein Substrat 26, welches beispielsweise als DCB-Substrat ausgeführt ist, ist stoffschlüssig mit der haftvermittelnden Schicht 16 verbunden. Die stoffschlüssige Verbindung zwischen einer Metallisierung 28 des Substrats 26 und der haftvermittelnden Schicht 16 ist über eine Lötverbindungsschicht 29 ausgebildet. Alternativ kann die stoffschlüssige Verbindung durch Sintern hergestellt werden. Auf einer dem Kühlkörper 2 abgewandten Seite des Substrats 26 ist exemplarisch ein Halbleiterelement 30, welches als Insulated-Gate-BipolarTransistor (IGBT)ausgeführt ist, kontaktiert. Alternativ kann das Halbleiterelement 30 unter anderem als ein Metall-Oxid-Halbleiter-Feldeffekttransistoren (MOSFETs), als ein Leistungshalbleiter mit breiter Bandlücke, insbesondere GaN oder SiC Leistungshalbleiter, ausgeführt sein. Das Halbleiterelement 30 ist durch Löten oder Sintern stoffschlüssig mit dem Substrat 26 verbunden. Auf einer dem Kühlkörper 2 abgewandten Seite ist das Halbleiterelement 30 über Verdrahtungselemente 32 mit dem Substrat 26 verbunden.

Wie folgender Tabelle zu entnehmen ist, weist Eisen einen niedrigeren Ausdehnungskoeffizienten (CTE) als Kupfer auf.

| **Werkstoff** | **Wärmeleitfähigkeit [W/mK]** | **CTE [10e⁻⁶ Ke⁻¹ ]** |
|---|---|---|
| Kupfer | 390 | 17 |
| Eisen, rein | 40 | 12 |
| Aluminiumoxid | 35 | 8,1 |
| Aluminiumnitrid | 180 | 4,5 |
| Aluminium | 230 | 23,8 |

Durch die Beimischung von Eisen zum Kupfer des zweiten metallischen Werkstoffs wird der Ausdehnungskoeffizient, insbesondere im Bezug auf eine Aluminiumoxid- oder Aluminiumnitrid-Keramik des Substrats 26, angeglichen, sodass ein Durchbiegen oder ein Ablösen vermieden wird. Die weitere Ausführung des Kühlkörpers 2 in FIG 3 entspricht der Ausführung in FIG 2.

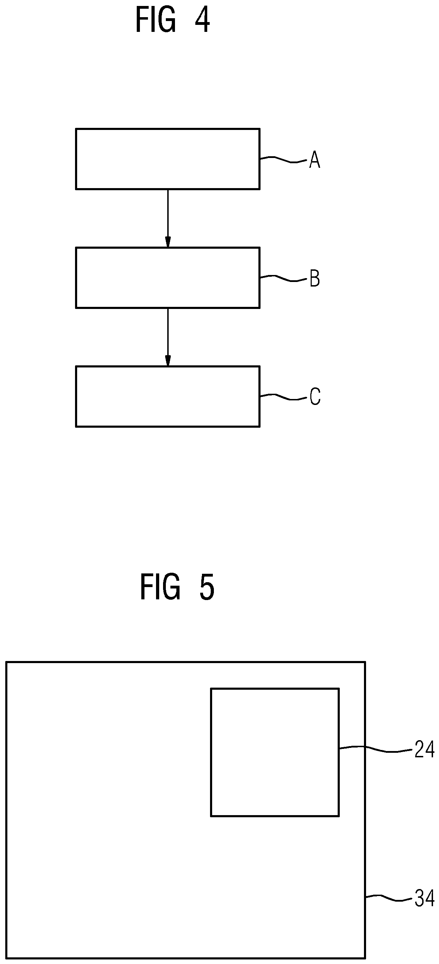

FIG 4 zeigt ein Ablaufdiagramm eines Verfahrens zur Herstellung einer Halbleiteranordnung. Das Verfahren umfasst nach dem Bereitstellen eines Kühlkörpers aus einem ersten metallischen Werkstoff ein flächiges Aufbringen A eines zweiten metallischen Werkstoffs, welcher sich vom ersten metallischen Werkstoff unterscheidet, auf zumindest einer, insbesondere ebenen, Oberfläche des Kühlkörpers. Das Aufbringen A des zweiten metallischen Werkstoffs erfolgt mittels eines thermischen Spritzverfahrens, wodurch eine haftvermittelnde Schicht ausgebildet wird. Der zweite metallische Werkstoff enthält erste Partikel und zweite Partikel, wobei sich die ersten Partikel und die zweiten Partikel zumindest hinsichtlich ihrer Wärmeleitfähigkeit und ihrer Härte unterscheiden.

In einem weiteren Schritt erfolgt ein stoffschlüssiges Verbinden B mindestens eines Substrats auf der haftvermittelnden Schicht. Das stoffschlüssige Verbinden B kann unter anderem durch Löten oder Sintern erfolgen.

In einem weiteren Schritt erfolgt ein Kontaktieren C mindestens eines Halbleiterelements auf einer dem Kühlkörper abgewandten Seite des Substrats. Das Kontaktieren C kann stoffschlüssig, z.B. durch Löten oder Sintern, aber auch kraftschlüssig, z.B. durch Anpressen, erfolgen.

FIG 5 zeigt eine schematische Darstellung eines Stromrichters 34 mit einer Halbleiteranordnung 24, welche wie in FIG 3 dargestellt ausgeführt ist. Der Stromrichter 34 kann mehr als eine Halbleiteranordnung 24 umfassen.

Zusammenfassend betrifft die Erfindung ein Verfahren zur Herstellung einer Halbleiteranordnung 24 mit einem Kühlkörper 2. Um die Herstellungskosten zu senken, werden folgende Schritte vorgeschlagen: Bereitstellen eines Kühlkörpers 2, der aus einem ersten metallischen Werkstoff hergestellt ist, Aufbringen A eines zweiten metallischen Werkstoffs, welcher sich vom ersten metallischen Werkstoff unterscheidet, mittels eines thermischen Spritzverfahrens zur Ausbildung einer haftvermittelnden Schicht 16 auf zumindest einer, insbesondere ebenen, Oberfläche 10 des Kühlkörpers 2, wobei der zweite metallische Werkstoff erste Partikel 20 und zweite Partikel 22 enthält, wobei die ersten Partikel 20 und die zweiten Partikel 22 aus unterschiedlichen Elementen oder Legierungen hergestellt sind, stoffschlüssiges Verbinden B mindestens eines Substrats 26 auf der haftvermittelnden Schicht 16.

## Patentansprüche

1. Verfahren zur Herstellung einer Halbleiteranordnung (24) mit einem Kühlkörper (2) umfassend folgende Schritte:
- Bereitstellen eines Kühlkörpers (2), der aus einem ersten metallischen Werkstoff hergestellt ist,
- Aufbringen (A) eines zweiten metallischen Werkstoffs, welcher sich vom ersten metallischen Werkstoff unterscheidet, mittels eines thermischen Spritzverfahrens zur Ausbildung einer haftvermittelnden Schicht (16) auf zumindest einer, insbesondere ebenen, Oberfläche (10) des Kühlkörpers (2), wobei der zweite metallische Werkstoff erste Partikel (20) und zweite Partikel (22) enthält,
wobei die ersten Partikel (20) und die zweiten Partikel (22) aus unterschiedlichen Elementen oder Legierungen hergestellt sind,
- stoffschlüssiges Verbinden (B) mindestens eines Substrats (26) auf der haftvermittelnden Schicht (16).

2. Verfahren nach Anspruch 1,
wobei sich die ersten Partikel (20) und die zweiten Partikel (22) zumindest hinsichtlich ihrer Wärmeleitfähigkeit und/oder ihrer Härte unterscheiden.

3. Verfahren nach einem der Ansprüche 1 oder 2,
wobei die zweiten Partikel (22) einen geringeren thermischen Ausdehnungskoeffizienten als die ersten Partikel (20) aufweisen.

4. Verfahren nach einem der vorherigen Ansprüche,
wobei die ersten Partikel (20) Kupfer und/oder Aluminium und die zweiten Partikel (22) Eisen und/oder Zinn enthalten.

5. Verfahren nach einem der vorherigen Ansprüche,
wobei der Kühlkörper (2) aus einer Aluminiumlegierung mittels Strangpressen hergestellt wird.

6. Verfahren nach einem der vorherigen Ansprüche,
wobei der Anteil von ersten Partikeln (20) mindestens 60 % beträgt.

7. Verfahren nach einem der vorherigen Ansprüche,
wobei sich die Partikel (20, (22) hinsichtlich ihrer Korngrö-βe unterscheiden.

8. Verfahren nach Anspruch 7,
wobei sich die Partikel (20, 22) jeweils aus einem groben Pulver und aus einem feinen Pulver zusammensetzen,
wobei das feine Pulver durch einen Recyclingprozess gewonnen wird.

9. Verfahren nach einem der vorherigen Ansprüche,
wobei mittels des thermischen Spritzverfahrens eine haftvermittelnde Schicht (16) mit einer, insbesondere im Wesentlichen konstanten, Stärke (s) im Bereich von 5 µm bis 300 µm ausgebildet wird.

10. Verfahren nach einem der vorherigen Ansprüche,
wobei das stoffschlüssige Verbinden (B) des Substrats (26) mit der haftvermittelnden Schicht (16) durch Löten oder Sintern erfolgt.

11. Verfahren nach einem der vorherigen Ansprüche,
wobei nach dem stoffschlüssigen Verbinden (B) des Substrats (26) mindestens ein Halbleiterelement (30) auf einer dem Kühlkörper (2) abgewandten Seite des Substrats (26) kontaktiert wird.

12. Halbleiteranordnung (24) mit einem Kühlkörper (2) aus einem ersten metallischen Werkstoff,
wobei auf zumindest einer, insbesondere ebenen, Oberfläche (10) des Kühlkörpers (2) eine haftvermittelnde Schicht (16) aus einem zweiten metallischen Werkstoff, welcher sich vom ersten metallischen Werkstoff unterscheidet, angeordnet ist,
wobei die haftvermittelnde Schicht (16) mittels eines thermischen Spritzverfahrens aus ersten Partikeln (20) und zweiten Partikeln (22) des zweiten metallischen Werkstoffs hergestellt ist,
wobei die ersten Partikel (20) und die zweiten Partikel (22) aus unterschiedlichen Elementen oder Legierungen hergestellt sind,
wobei ein Substrat (26) stoffschlüssig auf der haftvermittelnden Schicht (16) verbunden ist.

13. Halbleiteranordnung (24) nach Anspruch 12,
wobei sich die ersten Partikel (20) und die zweiten Partikel (22) zumindest hinsichtlich ihrer Wärmeleitfähigkeit und/oder ihrer Härte unterscheiden.

14. Halbleiteranordnung (24) nach einem der Ansprüche 12 oder 13,
wobei die ersten Partikel (20) Kupfer und/oder Aluminium und die zweiten Partikel (22) Eisen enthalten.

15. Stromrichter (34) mit mindestens einer Halbleiteranordnung (24) nach einem der Ansprüche 12 bis 14.
